# EUROPEAN PATENT SPECIFICATION

(11) **EP 3 682 207 B1**
(45) Date of publication and mention of the grant of the patent: **27.10.2021**
(21) Application number: 18783207.6
(22) Date of filing: 13.09.2018
(51) Int. Cl.: G01K 7/16, G01K 1/14, G01K 15/00, H01L 29/20, H01L 29/423, H01L 29/66, H01L 29/737, H01L 29/73, H01L 29/08

(54) **OPERATIONAL TEMPERATURE DETERMINATION IN BIPOLAR TRANSISTORS BY RESISTANCE THERMOMETRY**
BETRIEBSTEMPERATURBESTIMMUNG BEI BIPOLAREN TRANSISTOREN DURCH WIDERSTANDSTHERMOMETRIE
DÉTERMINATION DE LA TEMPÉRATURE DE FONCTIONNEMENT DANS DES TRANSISTORS BIPOLAIRES PAR THERMOMÉTRIE PAR RÉSISTANCE

(30) Priority: 14.09.2017 US 201715704998
(43) Date of publication of application: 22.07.2020
(73) Proprietor: MACOM Technology Solutions Holdings, Inc., Lowell, Massachusetts 01851 (US)
(72) Inventor: MAHON, Simon John, Avalon Beach, NSW 2107 (AU); HANSON, Allen W., Cary, NC 27519 (US); SCHWITTER, Bryan, Marrickville, NSW 2204 (AU); LIAN, Chuanxin, Westford, MA 01886 (US); BASKARAN, Rajesh, Dracut, MA 01826 (US); GAO, Frank, North Chelmsford, MA 01863 (US)
(74) Representative: Cabinet Beaumont
(86) International application number: PCT/US2018/050859
(87) International publication number: WO 2019/055641

(56) References cited:
- CN-A- 1 106 572
- DE-A1-102007 039 951
- US-A1- 2015 003 490
- US-B2- 8 710 615

## Description

### BACKGROUND

### Technical Field

The technology relates to bipolar transistors having internal temperature-sensing components.

### Discussion of the Related Art

Among III-V semiconductor materials, gallium-nitride (GaN) has received appreciable attention in recent years because of its desirable electronic and electro-optical properties. Gallium nitride (GaN) has a wide, direct bandgap of about 3.4 eV, is more resistant to avalanche breakdown, and has a higher intrinsic field strength compared to more common semiconductor materials, such as silicon. In addition, GaN is able to maintain its electrical performance at higher temperatures as compared to other semiconductors, such as silicon or gallium arsenide. GaN also has a higher carrier saturation velocity compared to silicon. Additionally, GaN has a Wurtzite crystal structure, is a hard material, has a high thermal conductivity, and has a much higher melting point than other conventional semiconductors such as silicon, germanium, and gallium arsenide.

Because of its desirable properties, GaN is useful for high-speed, high-voltage, and high-power applications, as well as optoelectronic applications. For example, gallium-nitride materials may be used to make active circuit components (e.g., field-effect transistors such as high-electron mobility transistors, bipolar-junction transistors such as heterojunction bipolar transistors) for semiconductor amplifiers (such as Doherty amplifiers) that may be used for radio-frequency (RF) communication, radar, and microwave applications. In high-power applications, transistors formed from GaN or other semiconductor materials (*e.g.,* Si, SiC, SiGe, GaAs, InP *etc.*) may be driven near their performance limits and heat up to temperatures well over 120 °C. Excessively high temperatures can lead to premature device degradation and/or failure in semiconductor transistors. An example of a bipolar junction transistor with an integrated temperature sensing resistor can be found in CN 1106572A.

### SUMMARY

According to the invention, a bipolar junction transistor as defined in claim 1 is provided.

The foregoing apparatus and method embodiments may be implemented with any suitable combination of aspects, features, and acts described above or in further detail below. These and other aspects, embodiments, and features of the present teachings can be more fully understood from the following description in conjunction with the accompanying drawings.

### BRIEF DESCRIPTION OF THE DRAWINGS

The skilled artisan will understand that the figures, described herein, are for illustration purposes only. It is to be understood that in some instances various aspects of the embodiments may be shown exaggerated or enlarged to facilitate an understanding of the embodiments. The drawings are not necessarily to scale, emphasis instead being placed upon illustrating the principles of the teachings. In the drawings, like reference characters generally refer to like features, functionally similar and/or structurally similar elements throughout the various figures. Where the drawings relate to microfabricated circuits, only one device and/or circuit may be shown to simplify the drawings. In practice, a large number of devices or circuits may be fabricated in parallel across a large area of a substrate or entire substrate. Additionally, a depicted device or circuit may be integrated within a larger circuit.

When referring to the drawings in the following detailed description, spatial references "top," "bottom," "upper," "lower," "vertical," "horizontal," "above," "below" and the like may be used. Such references are used for teaching purposes, and are not intended as absolute references for embodied devices. An embodied device may be oriented spatially in any suitable manner that may be different from the orientations shown in the drawings.
**FIG. 1A** is an elevation view that depicts structure of a heterojunction bipolar transistor (HBT), according to some embodiments;
**FIG. 1B** depicts a plan view of base contacts, emitter contacts, and collector contacts for an HBT, according to some embodiments;
**FIG. 2A** is an elevation view of an HBT that includes a thermal-sensing strip, according to some embodiments;
**FIG. 2B** depicts a plan view of a thermal-sensing strip and related structure, according to some embodiments;
**FIG. 2C** depicts a plan view of a thermal-sensing strip and related structure, according to some embodiments;
**FIG. 3** depicts temperature-sensing circuitry that may be used to monitor temperature in a bipolar junction transistor, according to some embodiments;
**FIG. 4** depicts temperature-sensing circuitry that may be used to monitor temperature in a bipolar junction transistor, according to some examples not forming part of the present invention;
**FIG. 5** plots measured resistance of a thermally-sensitive structure as a function of baseplate temperature, according to some embodiments;
**FIG. 6** plots measured resistance of a thermally-sensitive structure as a function of amplifier operating power for different baseplate temperatures, according to some embodiments;
**FIG. 7** plots inferred temperatures of a thermally-sensitive structure as a function of amplifier operating power at different baseplate temperatures and is based on the results of **FIG. 6**, according to some embodiments; and
**FIG. 8** plots calculated thermal resistance of a thermally-sensitive structure as a function of baseplate temperature and is based on the results of FIG. 7, according to some embodiments.

Features and advantages of the illustrated embodiments will become more apparent from the detailed description set forth below when taken in conjunction with the drawings.

### DETAILED DESCRIPTION

Bipolar junction transistors (BJTs) are currently used in a wide variety of applications including, but not limited to, audio amplifiers, television electronics, cell phones, communication electronics, and high-speed digital logic. There are many different designs of BJTs and several different types of BJTs. One type that is useful for high-power and high-speed applications is a heterojunction bipolar transistors (HBT). In an HBT, two different semiconductor materials may be used. For example, a first semiconductor material may be used for the emitter and a second semiconductor material may be used for the base and collector. In high-power applications, a BJT may heat to high temperatures (e.g., in excess of 120 °C), which may degrade device operation or damage the device. In some applications, it may be desirable to know more accurately a temperature that the transistor attains and/or monitor the temperature of the transistor when placed in service. The inventors have recognized and appreciated that localized "hot spots" (regions of significantly higher temperatures than surrounding regions) can occur within a transistor and that it is desirable to know more accurately the temperature of such hot spots.

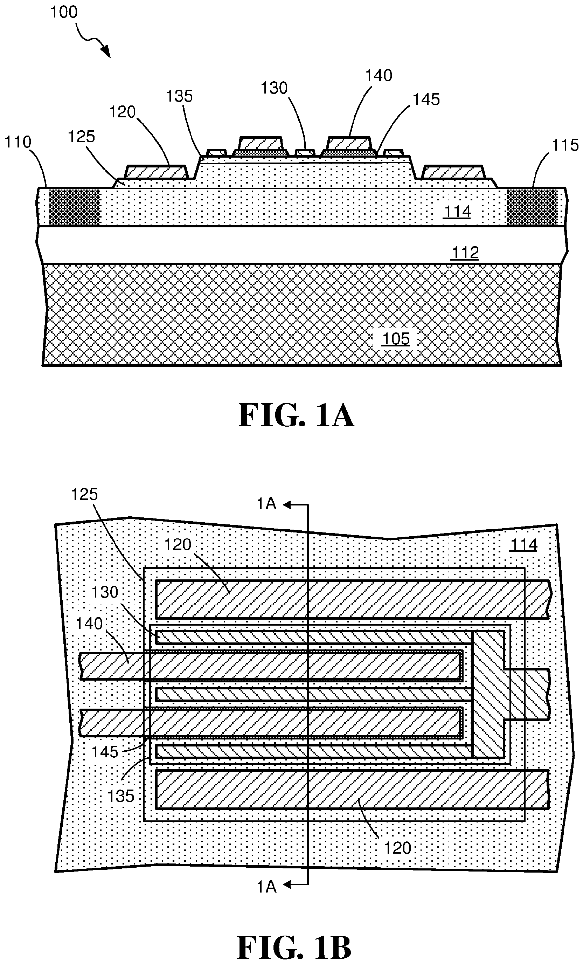

An example BJT structure to which aspects of temperature sensing may be applied is depicted in **FIG. 1A** and **FIG. 1B**, though the inventive aspects are not limited to the design and type of BJT shown in the drawing. According to some embodiments, a BJT may comprise a heterostructure bipolar transistor 100. An HBT 100 may be formed as a vertical-junction device on a bulk substrate 105 and comprise a collector region 125, a base layer 135, and emitter layers 145. Though an HBT is described to explain some embodiments of the technology, other transistor types and designs may be adapted for temperature sensing.

The bulk substrate 105 may comprise any suitable semiconductor material (e.g., Si, SiC, Ge, GaAs, InP, *etc.*)*,* which may be different from the material or materials from which the collector region 125, base layer 135, and emitter layers 145 are formed. In some embodiments, there may be one or more transition layers 112, 114 between the bulk substrate 105 and the collector region 125. The transition layers may be used to transition from a first crystal lattice of the bulk substrate 105 (*e.g.,* Si or SiC) to a second crystal lattice of the collector region (*e.g.,* GaN). For example, a first transition layer 112 may comprise AlN and a second transition layer 114 may comprise a GaN buffer layer, which may or may not have graded impurity doping. Other semiconductor materials may be used for the transition layers in other embodiments in which the BJT is formed from a material other than GaN.

According to some embodiments, a collector region 125 may be formed of a first semiconductor material that is doped to have a first conductivity type (*e.g.,* p-type). In some cases, the collector region may comprise a semiconductor collector mesa that rises above a planar surface 110 of the substrate. There may be one or more collector contacts 120 (two shown) deposited on the collector region 125. The collector contacts 120 may provide ohmic contacts to the collector region and connect to metal interconnects (not shown) over which a connection to a reference potential and/or other circuitry may be made.

A base layer 135 may be formed from the first semiconductor material and may be doped to have a second conductivity type (*e.g.,* n-type). In some cases, the base layer may comprise a base mesa that rises above the collector mesa. There may be one or more base contacts 130 (three shown) deposited on the base layer 135. The base contacts 130 may provide ohmic contacts to the base layer and connect to metal interconnects (not shown) over which signals may be applied to operate the BJT.

In some implementations, one or more emitter layers 145 may be formed over the base layer 135 and may be doped to have a first conductivity type (*e.g.,* p-type). In other implementations, the conductivity type of the emitter layers 145, base layer 135, and collector region 125 may be opposite those described above to form an *npn* transistor. According to some aspects, the emitter layer(s) 145 may be formed from a second semiconductor material that is different from the first semiconductor material that is used to form the collector region 125 and base layer 135 (*e.g.,* for an HBT). In other implementations, the emitter layer(s), base layers, and collector region may be formed from a same semiconductor material. In some cases, the emitter layer(s) may comprise an emitter mesa that rises above the base mesa. There may be one or more emitter contacts 140 (two shown) deposited on the emitter layer(s) 145. The emitter contacts 140 may provide ohmic contacts to the emitter layers and connect to metal interconnects (not shown) over which a connection may be made to a reference potential and/or other circuitry.

Although depicted as a vertical-junction device, some embodiments may comprise lateral-junction BJTs and HBTs that can be adapted for temperature sensing. A vertical-junction device with mesas may provide better electrical isolation between base, emitter, and collector contacts in a more compact device size. Regardless of the device orientation, there may be electrical isolation regions 115 formed around the devices to electrically isolate a transistor from other devices formed on the same bulk substrate 105. The isolation regions may comprise insulating oxide in some embodiments (e.g., a shallow trench isolation oxide), an undoped region of semiconductor in some cases, or may comprise damaged doped or undoped semiconductor in other embodiments (e.g., damaged by ion implantation to increase resistance to leakage current flow).

In some embodiments, one or more of the collector contacts 120, base contacts, 130, and emitter contacts 140 may be elongate fingers that run across an area of the substrate occupied by the BJT, as depicted in **FIG. 1B****.** The length of the fingers may be any value between 0.5 micron and 50 microns, or approximately these values. Some embodiments may include fingers having shorter or longer lengths. An aspect ratio (length:width) of the fingers may be between 5:1 and 30:1, or between approximately these values.

Although only a single BJT device is depicted in the drawings, in some implementations a plurality of BJTs may be arrayed on a die and connected to operate in parallel on a same signal, *e.g.,* as a single amplifier. In some cases, arrays of BJTs may be employed for high-power applications. In some implementations, there may be a plurality of BJTs on a die that are configured to operate on different signals, of which some BJTs may operate near maximum current limits. In some implementations, BJTs described above and below may be connected in different types of integrated circuits on a die such as, but not limited to, amplifiers, current sources, signal switches, pulse-generation circuits, power converters, application-specific integrated circuits (ASICs), *etc.*

In applications such as radar, microwave, and RF communication, amplification or switching of signals at high power levels often occurs. For example, an amplifier may amplify signals to power levels of tens or hundreds of Watts for transmission over long distances. The high power levels can cause heating within the amplifying transistors which, if excessive, can lead to undesirable changes in device performance, premature aging, and/or device failure.

As noted above, the inventors have recognized and appreciated that the heating is non-uniform within a BJT. During operation, the heat will be highest where the current density is highest in the device. For the device shown in FIG. 1A, the highest temperatures can occur immediately below the emitter layers 145. Temperatures in this region can exceed 160 °C during operation of a BJT, in some implementations. Such elevated temperatures can accelerate aging of BJTs and reduce the mean time to failure (MTTF). Accelerated aging is believed to be due, at least in part, to an increased rate of compound formation at material interfaces within the device. In some cases, prolonged excessive temperatures may lead to sudden device failure (by decreasing the device's resistance to high-voltage breakdown, for example).

To aid in device operation, it would be desirable to sense the temperature of the BJT near the region of highest temperature in the device. The ability to sense the operating temperature of a BJT locally at a region of a transistor, rather than globally sensing a temperature of a die or region of the die that may be remote from the transistor, can provide more accurate knowledge of the transistor's actual temperature and allow better operation of a device and/or circuit in which the transistor is located. For example, local sensing of transistor temperature during operation may allow all devices on the die to be run closer to their limits, rather than restricting device operation with a large safety margin based on a globally-sensed temperature. Further, local sensing of transistor temperature during operation may allow corrective action to be taken on "hot" transistors (e.g., reduction of signal input, reduction of transistor bias and gain, disabling the transistor, *etc.*)

To better understand heating in BJTs, the inventors have conceived of thermally-sensitive structures and methods for monitoring temperature within a BJT using metal resistance thermometry (MRT). In some implementations, thermally-sensitive structure near the emitter contact(s) 140 and/or base contact(s) 130 may be used to monitor BJT temperature locally. According to some examples not forming part of the present invention, an emitter contact 140 and/or base contact 130 may comprise thermally-sensitive structure. In some cases, sensed temperature values may be used in a feedback paradigm to control operation of a BJT, so as to reduce the operating temperature of the BJT.

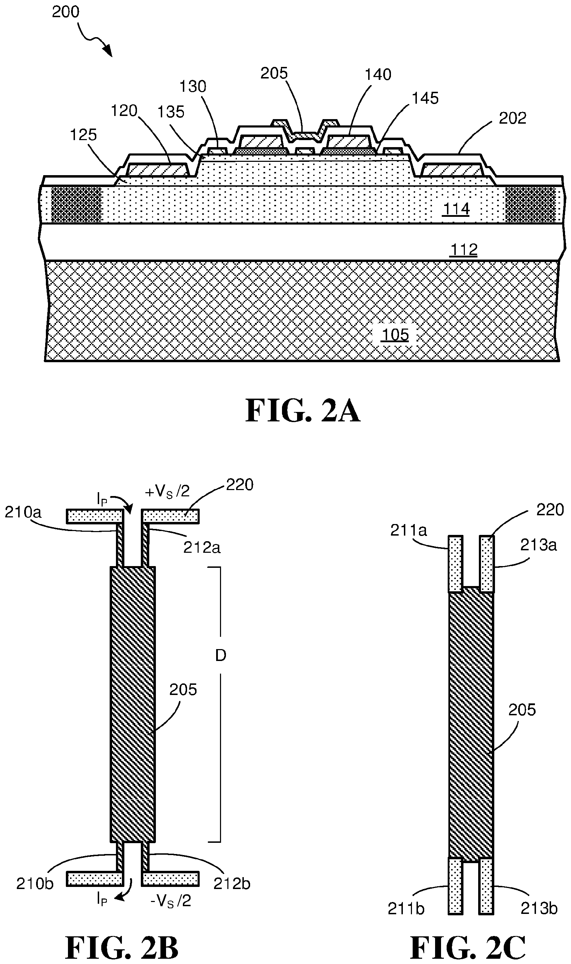

Referring now to the elevation view of **FIG. 2A** and according to the invention, a BJT includes one or more thermal-sensing strips 205 located in a region of a bipolar transistor 200. For example, a thermal-sensing strip 205 may be located within a few microns of a region of the transistor 200 where current density between the device's emitter and collector is highest. The BJT may otherwise be similar to the structure described for **FIG. 1A**. According to the invention, the thermal-sensing strip 205 is isolated from the base contact(s) 130, collector contact(s) 120, and emitter contact(s) 140 by an insulating layer 202 *(e.g.,* an oxide layer or other dielectric layer). A thickness of the insulating layer 202 may be between 20 nm and 1 micron, or between approximately these values.

When BJTs are formed in arrays, a thermal-sensing strip 205 may be formed on each transistor in the array, so that each transistor's temperature can be monitored independently, according to some embodiments. Alternatively, a thermal-sensing strip 205 may be formed on one (*e.g.,* one at or near the center of the array) or a few transistors distributed along an array to sample one or more representative temperatures in the array.

According to the present invention, a thermal-sensing strip 205 extends along and overlays a portion or all of an emitter contact 140. Additionally, a thermal-sensing strip 205 may extend along and overlay a portion or all of a base contact 130. In some cases, a thermal-sensing strip 205 may extend along and overlay a portion or all of a collector contact 120. In some implementations, a thermal-sensing strip 205 may be arranged so that it minimally or does not overlap a base contact or an emitter contact.

Offsetting the thermal-sensing strip 205 from the emitter, base, and collector contacts may reduce capacitive coupling between the thermal-sensing strip and an underlying contact, so as to reduce an adverse effect on transistor speed. The length of a thermal-sensing strip 205 may be less than or slightly longer than an emitter contact 140 or base contact 130 on a BJT for which thermal sensing is implemented. A width of a thermal-sensing strip 205 may be between 20 nm and 5 microns, or between approximately these values according to some embodiments. A thickness of a thermally-sensitive structure, such as the thermal-sensing strip 205, may be between 20 nanometers and 2 microns, or between approximately these values. Other sizes may be used for a thermally-sensitive structure in other embodiments.

When using the terms "on," "adjacent," or "over" to describe the locations of layers or structures, there may or may not be one or more layers of material between the described layer and an underlying layer that the layer is described as being on, adjacent to, or over. When a layer is described as being "directly" or "immediately" on, adjacent to, or over another layer, no intervening layer is present. When a layer is described as being "on" or "over" another layer or substrate, it may cover the entire layer or substrate, or a portion of the layer or substrate. The terms "on" and "over" are used for ease of explanation relative to the illustrations, and are not intended as absolute directional references. A device may be manufactured and/or implemented in other orientations than shown in the drawing (for example, rotated about a horizontal axis by more than 90 degrees.

In further detail, plan views of different embodiments of a thermal-sensing strip 205 are illustrated in **FIG. 2B** and **FIG. 2C**. Other configurations of the thermal-sensing strip 205 are also possible, and the invention is not limited to only the layout patterns shown. According to some embodiments, a thermal-sensing strip 205 may be configured for four-point probing, so that four-terminal Kelvin resistance measurements may be made, for example. In some cases, there may be one or two pairs of conductors (e.g., conductive contact tabs 210a, 210b, 212a, 212b) that provide electrical connection to the thermal-sensing strip 205. The conductors in a pair of contact tabs may be spaced apart *(e.g.,* located in distant or opposite end regions of the thermally-sensitive structure) according to some embodiments. In some implementations, the contact tabs of a pair may not be located at the ends of the thermal-sensing strip, and may be located at different points along the thermal-sensing strip 205. In preferred cases, at least two of the contact tabs (212a, 212b) are spaced apart on the thermal-sensing strip 205 by a distance D that is large enough to measure changes in a voltage drop along the thermal-sensing strip when a current is forced along the thermal-sensing strip 205.

In some cases, the contact tabs 210a, 210b, 212a, 212b may be electrically isolated by intervening insulating material from interconnects (not shown) that provide electrical connections to the base contact(s) 130, collector contact(s) 120, and emitter contact(s) 140. According to some embodiments, the contact tabs 210a, 210b, 212a, 212b may be formed from the same material as the thermal-sensing strip 205 and patterned at the same time. In other embodiments, the contact tabs may be formed from a different material than the thermal-sensing strip 205 and deposited in electrical contact with the thermal-sensing strip during a separate processing step. In some cases, the contact tabs may be formed as conductive interconnects. The conductive interconnects may comprise patterned traces formed from a metal layer (as depicted in **FIG. 2B**) or may comprise conductive vias that connect between the thermal-sensing strip and patterned traces formed in a metal layer above the thermal-sensing strip.

Although the diagram of **FIG. 2B** shows two pairs of contact tabs connecting to the thermal-sensing strip 205, other embodiments may comprise a single pair of contact tabs. In such an embodiment, each contact tab may connect to a large contact pad or branch to two signal paths, so that probing current can be applied through at least a portion of the thermal-sensing strip 205 and voltage sensing along at least a portion of the plate 205 can be performed.

In operation and referring to **FIG. 2B**, a probe current *I_{P}* may be applied through a first pair of contact tabs 210a, 210b that connect to a thermal-sensing strip 205. The applied current may be a DC current or an AC current. The probe current *I_{P}* may be applied in a region of the thermal-sensing strip 205 running adjacent to a base contact 130 and/or emitter contact 140 (not shown in **FIG. 2B**). While the probe current *I_{P}* is applied, a voltage Vs may be monitored across at least a portion of the region in which the current flows using a second pair of contact tabs (212a, 212b). From the measured voltage *V_{S}* and known value of applied current *I_{P},* a resistance value *R_{S}* can be determined for the probed region of the thermal-sensing strip 205. The amount of applied probe current may be between 200 microamps and 10 milliamps, or between approximately these values, according to some embodiments.

Many metals or materials that are used for base contacts, emitter contacts, or collector contacts have a resistance that is temperature sensitive Rs(T). Such metals or materials may be used for thermally-sensitive structure in a transistor, according to some embodiments. The temperature-dependent resistivity will be reflected in the measured voltage *V_{S}*(T). Accordingly, monitoring the voltage *V_{S}*(T) of a microscale thermally-sensitive structure within a BJT can provide an indication of the operational temperature of the BJT at a location that is close to a region of highest temperature in the transistor.

Materials that may be used for the thermal-sensing strip 205 or other thermally-sensitive structures described herein are numerous. A single metal or material layer may be used in some cases, or multilayer metal stacks may be used in other cases. In some implementations, non-metal materials such as polysilicon may be used. Example metal stacks that may be used include, but are not limited to, Ni/Au, Ni/Au/Ti, Ti/Pt/Au, Ti/Au, Ti/Pt/Au/Ti, Ni/Pd/Au/Ti, Ni/Pt/Au/Ti, Ni/Ti/Al/W, Ni/W/Al/W, Ni/Ta/Al/Ta, Ni/Ta/Al/W, Ni/NiO/Al/W, Ni/NiO/Ta/Al/Ta, Ni/NiO/Ta/Al/W, W/Al/W, Ni/WN/Al/W, Ni/NiO/W/Al/W, Ni/NiO/WN/Al/W, WN/Al/W, Pt/Au/Ti, Ti/Pt/Au, Al/Cu, Ni/Cr, or TiN/Cu. Single metal layers may be formed from any one of the metals in these multilayer stacks.

In practice, a base contact 130 may be driven at RF frequencies (e.g., frequencies over 500 MHz and as high as 7 GHz) for communications applications. Higher frequencies may be used in other embodiments. In high-frequency applications, it may be desirable to reduce adverse coupling of the RF signal to temperature-sensing circuitry connected to the thermally-sensitive structure. (The temperature-sensing circuitry is not shown in **FIG. 2B** or **FIG. 2C**). According to some embodiments, coupling of the RF signal to thermally-sensitive structure and/or its circuitry may be reduced by adding high-impedance elements 220 between the thermally-sensitive structure and the connected temperature-sensing circuitry. According to some embodiments, an inductance or resistance, or combination thereof, may be used as a high-impedance element 220, though a capacitor may be used alternatively or additionally in embodiments in which an applied probe current *I_{P}* is an AC current.

In some implementations, a high-impedance element 220 (four shown in **FIG. 2B**) comprises a resistor, *e.g.,* a thin-film resistor or a resistive via. A thin-film resistor or resistive via may be formed from TaN, for example, polysilicon, or any other suitable material. A resistive high-impedance element 220 may have a resistance value between 300 ohms and 2000 ohms, or between approximately these values. According to some embodiments, the resistance value may be between 500 ohms and 1500 ohms. In some cases, high-impedance elements 220 may be formed on a same die as the transistor for which temperature sensing is implemented. In some cases, high-impedance elements may be formed on a separate die (packaged with the transistor, for example) or located on a circuit board (on which the transistor is mounted, for example) and electrically connect to contact tabs of the thermal-sensing strip 205, for example. In some cases, a high-impedance element 220 may comprise a discrete resistor that can be mounted external to a packaged transistor that includes thermally-sensitive structure. The package may include pins for connecting resistors as the high-impedance elements 220. High-impedance elements 220 formed on a same die as the transistor may allow for a more compact assembly than having external discrete resistors. Alternatively, external resistors may allow for more design flexibility by a customer.

According to some implementations, contact tabs 211a, 211b, 213a, 213b may be formed as thin-film resistors or resistive vias, as depicted in FIG. 2C. The thin-film resistors may be deposited and patterned before or after the thermal-sensing strip 205. The resulting contact tabs 211a, 211b, 213a, 213b may form ohmic contacts at one end to the thermal-sensing strip 205, and connect, or provide connection points, at opposing ends to temperature-sensing circuitry.

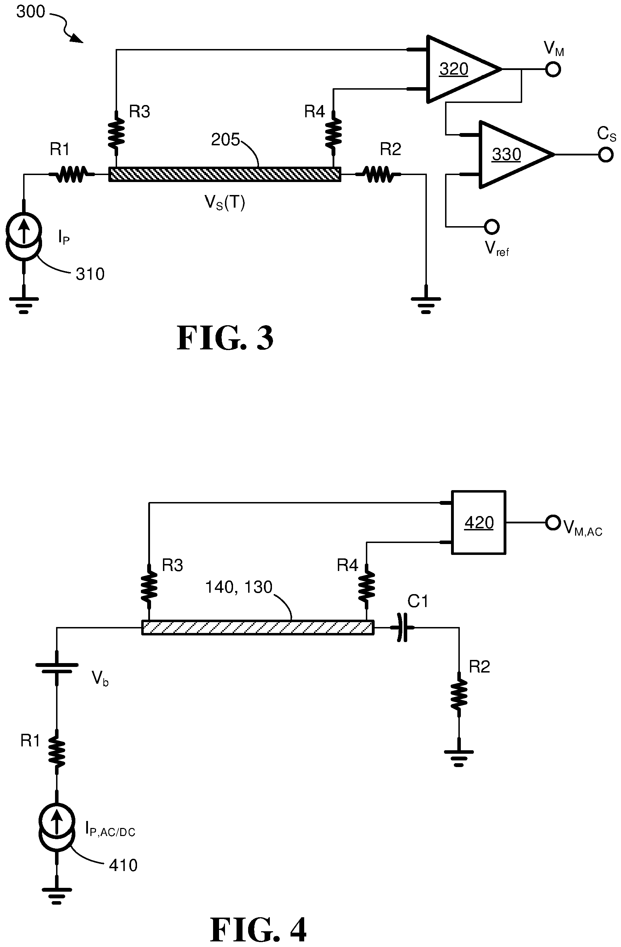

One example of temperature-sensing circuitry 300 that includes a thermal-sensing strip 205 formed on a transistor (not shown) is depicted in **FIG. 3**, according to some embodiments. Temperature-sensing circuitry 300 may comprise a source of current 310 and a differential amplifier 320, for example. Temperature-sensing circuitry 300 may also include high-impedance elements 220 described above and shown in **FIG. 3** as resistors R1-R4. In some implementations, the source of current 310 may comprise an integrated current source formed from one or more transistors, for example. The source of current 310 may be formed on a same die as the transistor and thermal-sensing strip 205, or may be formed on a separate die in some cases. The source of current 310 may be configured to provide DC current, for the embodiment depicted in **FIG. 3**, or may be configured to provide AC current in other embodiments.

A differential amplifier 320 may comprise an integrated circuit having several transistors (e.g., two transistors in parallel circuit branches with their emitters or sources connected to a common current source). The differential amplifier may be configured to sense a difference in electric potential between two regions of the thermal-sensing strip 205, as depicted in **FIG. 3**. According to some embodiments, the differential amplifier 320 may comprise operational amplifier circuitry that provides finite differential gain for voltage sensed between the two regions of the thermal-sensing strip 205. The differential amplifier 320 may be formed on a same die as the transistor and thermal-sensing strip 205, or may be formed on a separate die.

An output *V_{M}* from the differential amplifier 320 may be used to monitor changes in a voltage drop across a region of the thermal-sensing strip 205 during operation of the transistor. As described above, the monitored voltage *V_{S}*(T) is temperature-dependent, and can provide an indication of the peak operating temperature of the transistor. In some implementations, the output voltage *V_{M}* may be processed to estimate and/or track an operating temperature of the BJT. For example, *V_{M}* may be converted to a temperature value as described herein, and the temperature value may be output as digital data and/or visually displayed on test equipment. In some cases, the temperature of a BJT may be monitored during device testing to assess how well a BJT may operate when placed in service and/or to estimate a MTTF of the BJT when placed in service. In some implementations, the BJT's temperature may be monitored during quality control procedures at a time of manufacture.

In some implementations, the output voltage *V_{M}* may be provided to a comparator 330 to determine whether or not a BJT is operating within a predetermined temperature limit. For example, the output voltage *V_{M}* may be compared against a preset reference voltage *V_{ref}* to produce a control signal *C_{S}.* The control signal may be fed back to control operation of the transistor. For example, the control signal may be used to change transistor biasing, voltage supply values, and/or change a variable attenuator on an input RF signal, so that the operating power of the transistor is changed to reduce temperature or to allow for a temperature increase when permitted. Other methods may be used to process *V_{M}* and generate a control signal Cs in other embodiments.

A feature of the thermal-sensing strip 205 is that temperature sensing can be achieved without making electrical connections to the transistor's base and emitter, which would be required for determining temperature of the transistor by monitoring its base-to-emitter voltage Vbe. The thermal-sensing strip 205 and its probing and sensing circuitry can be minimally coupled or uncoupled to the transistors operating circuitry.

In other embodiments, components other than a thermal-sensing strip 205 may be used as a thermally-sensitive structure in a BJT and other temperature-sensing circuits may be used in other embodiments. Further embodiments may be described using the illustration of **FIG. 4**. In some implementations not forming part of the present invention, an emitter contact 140 or base contact 130 of a BJT may be used to sense BJT temperature, as indicated in **FIG. 4**. In some embodiments, a collector contact 120 may be used to sense temperature, although a collector contact may be more remote from a high-temperature region of the BJT.

In some embodiments, an AC probe current *I*_{*P*, *AC*} from an AC current source 410 may be applied to the transistor's emitter contact 140 in addition to a reference potential. In some embodiments, an AC probe current *I_{P, AC}* from an AC current source 410 may be applied to the transistor's base contact 130 in addition to a base bias voltage *V_{b}.* An AC current source 410 may comprise an integrated oscillator and current amplifier, according to some embodiments. The AC current source 410 may be integrated on a same die as the transistor for which temperature sensing is implemented, or integrated on a separate die.

In other embodiments, a DC probe current *I_{P,DC}* from an DC current source 410 may be applied to the transistor's emitter contact 140 or base contact 130 in addition to a reference potential and base bias *V_{b}*, respectively. A DC current source 410 may comprise an integrated current source formed from one or more transistors, according to some embodiments. The DC current source 410 may be integrated on a same die as the transistor for which temperature sensing is implemented, or integrated on a separate die. The inventors have recognized and appreciated that application of a DC current to the base or emitter may affect transistor bias, since it will introduce a gradient in bias along the transistor. For high-power applications, such a gradient from a small amount of probe current *I_{P}* may not affect transistor operation appreciably. In BJTs that use multiple base or emitter fingers, only one of the fingers may be used for temperature sensing to reduce the effect of the probe current *I_{P}* on device operation.

According to some embodiments that employ an AC probe current *I_{P}*, an RC shunt comprising a capacitor C1 and resistor R2 may connect between a reference potential (e.g., ground) and the emitter contact 140 or base contact to provide a path for the AC probe current. The RC shunt may attach to the emitter contact or base contact at a region that is remote from a location at which the current source 410 connects to the emitter contact or base contact. To avoid interfering with an RF signal that is applied to the base for amplification, the frequency of the probing AC current may be significantly less than a characteristic frequency of the RF signal. A characteristic frequency of the RF signal may be the frequency of a carrier wave used to transmit data in RF communications, for example, or may be the carrier frequency of a radar pulse for radar applications.

In some implementations, the frequency of the probing AC current may differ from the characteristic frequency of the RF signal by not less than a factor of 25, or by not less than approximately this value. In some cases, the frequency of the probing AC current may differ from the characteristic frequency of the RF signal by not less than a factor of 10, or by not less than approximately this value. Various probing AC frequencies may be used. For example, the frequency of the probe current *I_{P}* may be approximately 1 MHz in some embodiments. In some cases, the probing AC frequency may be a value between 50 kHz and 5 MHz, or between approximately these values. Other embodiments may use a probing AC frequency having a value not less than 10 Hz, or not less than approximately this value. Other embodiments may use a probing AC frequency having a value up to 10's or hundreds of MHz. The RC shunt may comprise a low-pass filter that provides a path for the probe current but essentially blocks high frequencies. In some implementations, the value of C1 and R2 may be selected to provide a cut-off frequency for the RC shunt that is approximately equal to or up to 20% higher than a frequency of the probe current Ip.

When an AC probe current is used, AC voltage-sensing circuitry 420 may be employed. In some implementations, AC voltage-sensing circuitry may comprise an averaging peak-voltage detector. The AC voltage-sensing circuitry 420 may be integrated on a same die as the transistor for which temperature sensing is implemented, or integrated on a separate die. Feedback and transistor control circuitry, as described in connection with FIG. 3, may also be employed for embodiments that use at least one base contact 130 or at least one emitter contact 140 for temperature sensing. Such feedback and control circuitry may receive an output signal from the AC voltage-sensing circuitry 420 that is indicative of transistor temperature and produce a control signal *(e.g.,* based on a comparison with a reference signal) that is used to affect a change in operation of the transistor.

In some embodiments (such as a testing facility), one or both of the source of current 310, 410 and voltage-sensing circuit 320, 420 may be embodied as a commercial instrument or stand-alone test equipment. In such cases, probes may be used to connect to contact tabs or connected probe pads (not shown) on a die containing one or more transistors under test. Such embodiments may be used when testing or qualifying devices at manufacture, for example, and allow a more compact transistor die.

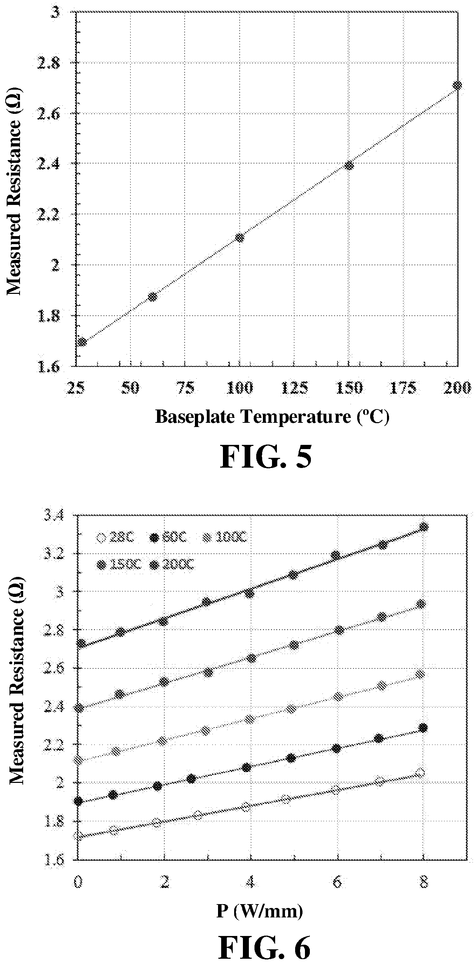

According to some embodiments, the temperature sensitivity of a thermally-sensitive structure (thermal-sensing strip 205, emitter contact 140, base contact 130) in a BJT may be calibrated using one or more BJTs on a die or wafer. For example, a die or wafer may be placed on a thermal plate and heated over a range of temperatures while the BJT's base, emitter, and collector contacts are left floating. The wafer or die may be allowed to reach thermal equilibrium at each temperature before resistance measurements are made with the thermally-sensitive structure. The resistance measurements may comprise applying a probe current *I_{P}* and sensing a voltage drop *V_{S}*(T) across a region of the thermally-sensitive structure in which the probe current flows. Results for such a calibration may appear as shown in **FIG. 5**.

The graph of **FIG. 5** shows resistance values (calculated from the applied current and measured voltage drops) plotted as a function of baseplate temperature for a thermally-sensitive structure formed in a high-electron mobility transistor (HEMT). In this example device, the change in resistance of the thermally-sensitive structure with respect to change in temperature of the structure is about 0.006 ohm/°C. Other embodiments with different materials may have different thermal sensitivity. In some cases, the thermal sensitivity may be between 0.001 ohm/ °C and 0.05 ohm/°C, or between approximately these values. In other cases the thermal sensitivity of the thermally-sensitive structure may have a lower or higher value than this range.

Data from a graph like the one of **FIG. 5**, when obtained for a BJT, may be used to evaluate temperatures of identical BJT devices (or similar BJT devices that include identical thermally-sensitive structures) that are used during normal operation. As an example, a calibration equation (e.g., an equation for a line that fits the data points in **FIG. 5**) or a look-up table may be determined from the measured resistance data and used to convert subsequently-measured resistance values to temperatures.

Although resistance is plotted in **FIG. 5**, other embodiments may use other values. In some cases, voltage may not be converted to resistance. Instead, measured voltage may be plotted as a function of baseplate temperature and voltage values may be used directly to evaluate temperatures of identical BJT devices that are probed during device operation. In other cases, sheet resistance (Ohm/square) may be determined for the thermally-sensitive structure and plotted as a function of temperature, so that the results may be used to evaluate temperatures in BJTs having a thermally-sensitive structure of a different shape and/or size, though having a same sheet resistance.

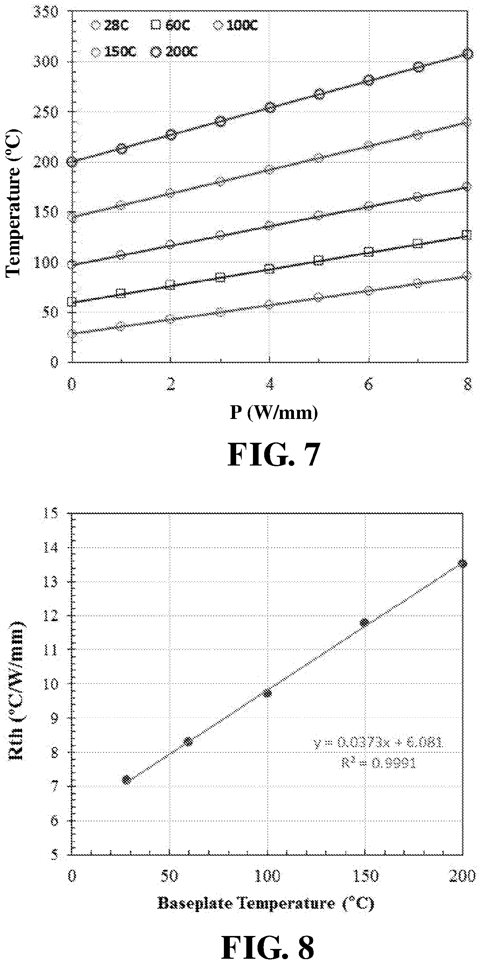

An example of using calibration values, such as those obtained for the example of **FIG. 5**, is described further in connection with **FIG. 6** and **FIG. 7**. To produce the graph of **FIG. 6**, a HEMT which included a thermally-sensitive plate similar to the thermal-sensing strip 205 described above was operated at different power levels (from 0 to approximately 8 W/mm) while a baseplate supporting the HEMT was sequentially set at five different temperatures. The plotted resistance values for each measurement shown in **FIG. 6** were determined from measured voltage drops *V_{S}*(T) across a region of the thermally-sensitive structure and the applied probe current Ip.

After finding the resistance values (plotted in **FIG. 6**) under the different operating conditions, the calibration values of **FIG. 5** (or a resulting calibration equation or look-up table) may be used to convert the measured resistances of **FIG. 6** to temperature values. The corresponding temperature values are plotted in **FIG. 7**, as an example of data conversion using the calibration data.

The slope of each line in **FIG. 7** represents the thermal resistance of the thermally-sensitive structure at a different baseplate operating temperature. Thermal resistance for the example device is plotted as a function of temperature in **FIG. 8**.

In a packaged power transistor, a thermal sink (e.g., thermally-conductive plate) may be included inside and/or external to the package to improve thermal conduction of heat away from the transistor. In some cases, there may be more than one thermal sink. In some embodiments, there may be additionally or alternatively a thermal sink external to the power transistor package to which the transistor package may be mounted. Some implementations may include a temperature sensor *(e.g.,* a thermistor) on a thermal sink, so that a temperature of the thermal sink can be monitored during operation of the power transistor. Accordingly, data like that shown in **FIG. 6** and **FIG. 7** may be used to estimate operating temperature of a power transistor using a measured resistance value for the thermally-sensitive structure (e.g., thermal-sensing strip 205) formed in the transistor and a measured temperature of a thermal sink that is in thermal contact with the power transistor.

It will be appreciated that the values plotted in **FIG. 5** through **FIG. 8** are for an example device and for explanation purposes only. Different values and calibration curves may be obtained for devices different from the example device. The invention is not limited to the values and calibration data shown in these figures.

Methods of operating BJTs in accordance with the above-described embodiments include acts for sensing and evaluating operating temperatures of BJTs. In some cases, values of sensed temperature may be used for feedback control of a BJT. A method of operating a bipolar junction transistor may comprise acts of applying a signal to a base contact of the transistor, amplifying the signal with the BJT, and further applying a probe current through a region of a thermally-sensitive structure (e.g., a thermal-sensing strip 205) that is formed in the BJT. The thermally-sensitive structure may be located within a few microns of a region of the BJT that attains a highest temperature when operating (e.g., near the device's emitter-to-base junction(s)). A method may further comprise sensing a voltage produced by the applied probe current. In some cases, the thermally-sensitive structure may comprise a base contact or an emitter contact.

A method of operating a BJT may include evaluating, from the sensed voltage, a temperature of the transistor that is representative of a localized "hot spot" or region of peak temperature within the transistor (e.g., a region near an emitter-base junction). The evaluation of temperature may comprise using calibration results for the BJT's thermally-sensitive structure. In some embodiments, sensed voltages may not be converted to temperature. Instead, the sensed voltages may be used as indicators of BJT temperature. For example, a method of operating a BJT may comprise acts of comparing a sensed voltage to a reference value. In some cases, a power level of the transistor may be controlled based upon the comparison.

In some aspects of temperature sensing, a method may comprise applying an alternating probe current through a region of a thermally-sensitive structure *(e.g.,* a thermal sensing plate 205, an emitter contact 140, a base contact 130). For some embodiments, applying the alternating current may comprise applying the alternating current at a first frequency that is different from a carrier-wave frequency by not less than a factor of 25. The carrier-wave frequency may be part of a signal that is amplified by the BJT.

Applying the probe current may comprise intermittently applying the probe current to a thermally-sensitive structure, such that the current is driven for intervals of time that are spaced apart by other intervals of time in which no probe current is applied to the thermally-sensitive structure. Intermittent application of a probe current may reduce power consumption and reduce potential interference with BJT operation. The probe current may be applied only at times during and/or immediately after an input signal rises above a predetermined power or voltage level. For example, a comparator may be connected to sense an input level applied to a base of a BJT, and activate a current source 310, 410 in response to the input level exceeding or falling below a reference value. In this manner, temperature sensing may be executed only during and/or immediately after the transistor handles large input signals (e.g., during and/or after peak power intervals).

Methods of operating BJTs that include temperature sensing may further include acts of amplifying signals for communication systems, medical imaging equipment, or microwave applications, for example, or switching voltages and/or currents for power conversion applications, power generation, snubber circuits, or overvoltage/overcurrent protection, for example. In power applications, a BJT with thermal sensing may be used in amplifiers (such as Doherty amplifiers) that amplify signals to power levels of not less than 0.25 Watts, or approximately this value. In some implementations, thermal sensing may be used in power amplifiers that amplify signals to power levels in a range of not less than 0.5 Watts and as high as 150 Watts, or between approximately these values. It will be appreciated that BJTs with temperature sensing may be used for various different transistor applications, and that temperature-sensing techniques that use a thermal-sensing strip 205 or existing base and emitter structures, as described herein, can have little or no impact on device fabrication and operation of the BJT.

### CONCLUSION

The terms "approximately" and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value.

The technology described herein may be embodied as a method, of which at least some acts have been described. The acts performed as part of the method may be ordered in any suitable way. Accordingly, embodiments may be constructed in which acts are performed in an order different than described, which may include performing some acts simultaneously, even though described as sequential acts in illustrative embodiments. Additionally, a method may include more acts than those described, in some embodiments, and fewer acts than those described in other embodiments.

The above-described embodiments of thermal sensing may be applied to various types and designs of bipolar transistors, and not only the particular transistors shown or described in connection with the drawings. Transistors to which the above-described embodiments may be applied may have active areas of semiconductor, controlled by the base voltage, formed from any suitable semiconductor material or materials such as, but not limited to, silicon (Si), germanium (Ge), silicon-germanium (SiGe), silicon-carbide (SiC), gallium-nitride material *(e.g.,* GaN), gallium-arsenide material *(e.g.,* GaAs), indium-phosphide material *(e.g.,* InP), cadmium-telluride material *(e.g.,* CdTe), *etc.*

As used herein, the phrase "gallium-nitride material" is used to refer to gallium nitride (GaN) and any of its alloys, such as aluminum gallium nitride (AlₓGa (₁₋ₓ)N), indium gallium nitride (In_{y}Ga(_{1-y})N), aluminum indium gallium nitride (AlₓIn_{y}Ga(_{1-x-y})N), gallium arsenide phosporide nitride (GaAsₓP_{y} N(_{1-x-y})), aluminum indium gallium arsenide phosporide nitride (AlₓIn_{y}Ga(_{1-x-y})AsₐP_{b} N(_{1-a-b})), amongst others. Typically, when present, arsenic and/or phosphorous are at low concentrations (*i.e.,* less than 5 percent by weight). In certain preferred embodiments, the gallium-nitride material has a high concentration of gallium and includes little or no amounts of aluminum and/or indium. In high gallium concentration embodiments, the sum of (x+y) may be less than 0.4 in some implementations, less than 0.2 in some implementations, less than 0.1 in some implementations, or even less in other implementations. In some cases, it is preferable for at least one gallium-nitride material layer to have a composition of GaN (*i.e.,* x=y=a=b=0). For example, an active layer in which a majority of current conduction occurs may have a composition of GaN. Gallium-nitride materials in a multi-layer stack may be doped n-type or p-type, or may be undoped. Suitable gallium-nitride materials are described in U.S. patent No. 6 649 287.

Similarly, a phrase *"compound semiconductor* material" is used to refer to the listed compound semiconductor (e.g., GaAs) and any of its alloys.

## Claims

1. A bipolar junction transistor (200) with temperature sensing components comprising:
a base contact (130);
an emitter contact (140);
a collector contact (120);
a thermally-sensitive structure (205) formed to overlay at least a portion of the emitter contact (140) and being electrically isolated from the emitter contact (140); and
a first pair of conductors (210a, 210b) coupled to the thermally-sensitive structure (205) and separated by a first distance for applying a probe current through the thermally-sensitive structure (205).

2. The bipolar junction transistor of claim 1, wherein the thermally-sensitive structure further overlays at least a portion of the base contact and is electrically isolated from the base contact by an insulating layer.

3. The bipolar junction transistor of claim 1 or 2, wherein the first pair of conductors include capacitive coupling.

4. The bipolar junction transistor of any of claims 1 to 3, wherein the thermally-sensitive structure exhibits a change in resistance with a change in temperature of the thermally-sensitive structure that is not less than 0.001 ohms/°C.

5. The bipolar junction transistor of any of claims 1 to 4, wherein the first pair of conductors comprise contact tabs patterned from a metal.

6. The bipolar junction transistor of any of claims 1 to 5, wherein the first pair of conductors comprise conductive vias connecting the thermally-sensitive structure to an interconnect on a different metal layer.

7. The bipolar junction transistor of any of claims 1 to 6, further comprising a first thin-film resistor and a second thin-film resistor connected to the first pair of conductors.

8. The bipolar junction transistor of claim 7, wherein a resistance of the first thin-film resistor and of the second thin-film resistor is not less than 300 ohms.

9. The bipolar junction transistor of any of claims 1 to 8, further comprising a second pair of conductors coupled to the thermally-sensitive structure and separated by a second distance for sensing a voltage that develops along the thermally-sensitive structure in response to application of the probe current.

10. The bipolar junction transistor of claim 9, further comprising voltage-sensing circuitry connected to the second pair of conductors.

11. The bipolar junction transistor of claim 10, wherein the voltage-sensing circuit provides an output signal to a feedback circuit that controls a power level of the bipolar junction transistor.

12. The bipolar junction transistor of any of claims 1 to 11, further comprising a source of the probe current connected to the first pair of conductors, wherein the source of the probe current is configured to provide alternating current.

13. The bipolar junction transistor of claim 12, wherein the alternating current has a frequency between 50 kilohertz and 5 megahertz.

14. The bipolar junction transistor of any of claims 1 to 13, wherein the bipolar junction transistor is incorporated in a power amplifier configured to amplify signals to a power level of at least 0.25 Watt.

15. The bipolar junction transistor of any of claims 1 to 14, wherein the bipolar junction transistor is formed as a heterojunction bipolar transistor.

## Patentansprüche

1. Bipolartransistor (200) mit temperaturerfassenden Komponenten, der Folgendes aufweist
einen Basiskontakt (130);
einen Emitterkontakt (140);
einen Kollektorkontakt (120);
eine wärmeempfindliche Struktur (205), die so ausgebildet ist, dass sie über mindestens einem Teil des Emitterkontakts (140) liegt und von dem Emitterkontakt (140) elektrisch getrennt ist; und
ein erstes Paar von Leitern (210a, 210b), die mit der wärmeempfindlichen Struktur (205) verbunden und durch einen ersten Abstand getrennt sind, um einen Messstrom durch die wärmeempfindliche Struktur (205) anzulegen.

2. Bipolartransistor nach Anspruch 1, wobei die wärmeempfindliche Struktur ferner über mindestens einem Teil des Basiskontakts liegt und durch eine Isolierschicht elektrisch vom Basiskontakt getrennt ist.

3. Bipolartransistor nach Anspruch 1 oder 2, wobei das erste Leiterpaar eine kapazitive Kopplung aufweist.

4. Bipolartransistor nach einem der Ansprüche 1 bis 3, wobei die wärmeempfindliche Struktur eine Widerstandsänderung mit einer Temperaturänderung der wärmeempfindlichen Struktur aufweist, die nicht weniger als 0,001 Ohm/°C beträgt.

5. Bipolartransistor nach einem der Ansprüche 1 bis 4, wobei das erste Leiterpaar aus Metall strukturierte Kontaktfahnen aufweist.

6. Bipolartransistor nach einem der Ansprüche 1 bis 5, wobei das erste Leiterpaar leitende Vias aufweist, die die wärmeempfindliche Struktur mit einem Verbindungspunkt auf einer anderen Metallschicht verbinden.

7. Bipolartransistor nach einem der Ansprüche 1 bis 6, der ferner einen ersten Dünnschichtwiderstand und einen zweiten Dünnschichtwiderstand aufweist, die mit dem ersten Leiterpaar verbunden sind.

8. Bipolartransistor nach Anspruch 7, wobei der Widerstand des ersten Dünnschichtwiderstandes und des zweiten Dünnschichtwiderstandes nicht weniger als 300 Ohm beträgt.

9. Bipolartransistor nach einem der Ansprüche 1 bis 8, der ferner ein zweites Paar von Leitern aufweist, die mit der wärmeempfindlichen Struktur gekoppelt und durch einen zweiten Abstand getrennt sind, um eine Spannung zu erfassen, die sich entlang der wärmeempfindlichen Struktur als Reaktion auf das Anlegen des Messstroms entwickelt.

10. Bipolartransistor nach Anspruch 9, der ferner eine Spannungserfassungsschaltung aufweist, die mit dem zweiten Leiterpaar verbunden ist.

11. Bipolartransistor nach Anspruch 10, wobei die Spannungserfassungsschaltung ein Ausgangssignal an eine Rückkopplungsschaltung liefert, die einen Leistungspegel des Bipolartransistors steuert.

12. Bipolartransistor nach einem der Ansprüche 1 bis 11, der ferner eine Quelle für den Messstrom aufweist, die mit dem ersten Leiterpaar verbunden ist, wobei die Quelle für den Messstrom so konfiguriert ist, dass sie Wechselstrom liefert.

13. Bipolartransistor nach Anspruch 12, wobei der Wechselstrom eine Frequenz zwischen 50 Kilohertz und 5 Megahertz hat.

14. Bipolartransistor nach einem der Ansprüche 1 bis 13, wobei der Bipolartransistor in einen Leistungsverstärker eingebaut ist, der so konfiguriert ist, dass er Signale auf einen Leistungspegel von mindestens 0,25 Watt verstärkt.

15. Bipolartransistor nach einem der Ansprüche 1 bis 14, wobei der Bipolartransistor als Heteroübergangs-Bipolartransistor ausgebildet ist.

## Revendications

1. Transistor à jonction bipolaire (200) muni de composants de détection de température, comprenant :
un contact de base (130) ;
un contact d'émetteur (140) ;
un contact de collecteur (120) ;
une structure thermosensible (205) formée de manière à recouvrir au moins une partie du contact d'émetteur (140) et qui est isolée électriquement du contact d'émetteur (140) ; et
une première paire de conducteurs (210a, 210b) couplés à la structure thermosensible (205) et séparés d'une première distance pour appliquer un courant de sonde à travers la structure thermosensible (205).

2. Transistor à jonction bipolaire selon la revendication 1, dans lequel la structure thermosensible recouvre en outre au moins une partie du contact de base et est isolée électriquement du contact de base par une couche isolante.

3. Transistor à jonction bipolaire selon la revendication 1 ou 2, dans lequel la première paire de conducteurs comprend un couplage capacitif.

4. Transistor à jonction bipolaire selon l'une quelconque des revendications 1 à 3, dans lequel la structure thermosensible présente un changement de résistance en fonction d'un changement de température de la structure thermosensible qui n'est pas inférieur à 0,001 ohm/°C.

5. Transistor à jonction bipolaire selon l'une quelconque des revendications 1 à 4, dans lequel la première paire de conducteurs comprend des languettes de contact formées à partir d'un métal.

6. Transistor à jonction bipolaire selon l'une quelconque des revendications 1 à 5, dans lequel la première paire de conducteurs comprend des vias conducteurs connectant la structure thermosensible à une interconnexion sur une couche métallique différente.

7. Transistor à jonction bipolaire selon l'une quelconque des revendications 1 à 6, comprenant en outre une première résistance à couche mince et une deuxième résistance à couche mince connectées à la première paire de conducteurs.

8. Transistor à jonction bipolaire selon la revendication 7, dans lequel la résistance de la première résistance à couche mince et de la deuxième résistance à couche mince n'est pas inférieure à 300 ohms.

9. Transistor à jonction bipolaire selon l'une quelconque des revendications 1 à 8, comprenant en outre une deuxième paire de conducteurs couplés à la structure thermosensible et séparés d'une deuxième distance pour détecter une tension qui se développe le long de la structure thermosensible en réponse à l'application du courant de sonde.

10. Transistor à jonction bipolaire selon la revendication 9, comprenant en outre un circuit de détection de tension connecté à la deuxième paire de conducteurs.

11. Transistor à jonction bipolaire selon la revendication 10, dans lequel le circuit de détection de tension fournit un signal de sortie à un circuit de rétroaction qui commande un niveau de puissance du transistor à jonction bipolaire.

12. Transistor à jonction bipolaire selon l'une quelconque des revendications 1 à 11, comprenant en outre une source du courant de sonde connectée à la première paire de conducteurs, la source du courant de sonde étant agencée pour fournir du courant alternatif.

13. Transistor à jonction bipolaire selon la revendication 12, dans lequel le courant alternatif a une fréquence comprise entre 50 kilohertz et 5 mégahertz.

14. Transistor à jonction bipolaire selon l'une quelconque des revendications 1 à 13, le transistor à jonction bipolaire étant incorporé dans un amplificateur de puissance agencé pour amplifier des signaux à un niveau de puissance d'au moins 0,25 Watt.

15. Transistor à jonction bipolaire selon l'une quelconque des revendications 1 à 14, le transistor à jonction bipolaire étant formé comme un transistor bipolaire à hétéro-jonction.
